# EUROPEAN PATENT SPECIFICATION

(11) **EP 1 451 854 B1**
(45) Date of publication and mention of the grant of the patent: **02.11.2005**
(21) Application number: 02796108.5
(22) Date of filing: 02.12.2002
(51) Int. Cl.: H01L 21/00

(54) **Wafer transfer member with electric conductivity and its manufacturing method**
Wafer-Transfervorrichtung mit elektrischer Leitfähigkeit und Verfahren zu dessen Herstellung
Dispositif de transfert de plaquette avec conductivité électrique et son procédé de fabrication

(30) Priority: 03.12.2001 US 334587 P
(43) Date of publication of application: 01.09.2004
(73) Proprietor: E.I.Du pont de nemours and company, Wilmington, DE 19898 (US); Nippon Oil Corporation, Tokyo 105-8412 (JP); Ishihara Chemical Company, Ltd., Tokyo 114-0012 (JP)
(72) Inventor: SAKAI, Shuji, Yokohama-shi, Kanagawa 223-0053 (JP); MILLER, Chris, L., Landenberg, PA 19350 (US); UCHIDA, Daisuke, Kanagawa-ken 211-0063 (JP); KOBAYASHI, Takashi, Kanagawa-ken 223-0061 (JP); AOYAGI, Kenichi, Kanagawa-ken 211-0063 (JP); YAMAMOTO, Shinji Annex-Pier #30847-3, Saitama-ken 359-0021 (JP)
(74) Representative: Gritschneder, Martin
(86) International application number: PCT/US2002/041653
(87) International publication number: WO 2003/049157

(56) References cited:
- US-A- 5 280 979
- PATENT ABSTRACTS OF JAPAN vol. 2000, no. 15, 6 April 2001 (2001-04-06) -& JP 2000 343476 A (NIPPON MITSUBISHI OIL CORP), 12 December 2000 (2000-12-12) cited in the application
- PATENT ABSTRACTS OF JAPAN vol. 1997, no. 03, 31 March 1997 (1997-03-31) -& JP 08 288190 A (HITACHI LTD;SEKISUI CHEM CO LTD), 1 November 1996 (1996-11-01)
- PATENT ABSTRACTS OF JAPAN vol. 016, no. 208 (M-1249), 18 May 1992 (1992-05-18) -& JP 04 035827 A (KYOCERA CORP), 6 February 1992 (1992-02-06)
- PATENT ABSTRACTS OF JAPAN vol. 012, no. 393 (E-670), 19 October 1988 (1988-10-19) -& JP 63 133644 A (HITACHI ELECTRONICS ENG CO LTD), 6 June 1988 (1988-06-06)
- PATENT ABSTRACTS OF JAPAN vol. 008, no. 053 (E-231), 9 March 1984 (1984-03-09) -& JP 58 207651 A (HITACHI SEISAKUSHO KK;OTHERS: 01), 3 December 1983 (1983-12-03)
- PATENT ABSTRACTS OF JAPAN vol. 016, no. 134 (E-1185), 6 April 1992 (1992-04-06) -& JP 03 296243 A (TOSHIBA CERAMICS CO LTD), 26 December 1991 (1991-12-26)

## Description

This application claims the benefit of U.S. Provisional Application No. 60/334,587, filed December 3, 2001.

### FIELD OF THE INVENTION

The present invention relates to a transfer member and its method of manufacture. More particularly, the present invention relates to a transfer member that is suitable for transferring precision equipment materials such as glass substrates for liquid-crystal display devices and silicon wafers for semiconductors, as well as its manufacturing method.

### BACKGROUND OF THE INVENTION

The following disclosures may be relevant to various aspects of the present invention and may be briefly summarized as follows:

In the manufacturing processes of precision machines such as liquid-crystal display devices and semiconductors, a transfer member for transferring these components is used. Such a transfer member may be installed in a device such as an industrial robot for moving the transfer member. The components are placed or held on the transfer member and moved to the desired location.

Transfer members are commonly made of a metal such as aluminum. However, with the increasing need to transfer large-scale liquid-crystal display device components or silicon wafers, a transfer part made of a lightweight carbon-fiber-reinforced plastic (CFRP) with high stiffness, small deflection, and high heat resistance is desirable. In the prior art, Japanese laid open (Kokai) patent No. 11-354607 discloses a hand of a transfer member comprising a laminate of a layer formed of carbon fibers and polymer and a layer of metal, Japanese laid open (Kokai) patent No.11-354608 discloses a hand of a transfer member comprising a laminate of a prepreg layer in which carbon fibers are arranged unidirectionally, and, Japanese laid open (Kokai) patent No.2000-343476 discloses a transfer member comprising a three-layer structure of skin layers of CFRP (carbon-fiber-reinforced plastics) and core layer.

However, in the manufacturing processes of precision machines such as liquid-crystal display devices and semiconductors, the reduction (or elimination) of the static electricity that accumulates on the components is also important. The static electricity on the integrated circuit and liquid-crystal device components discolors the surface by generating fine particles in work environments or causing a destructive discharge, so that the products are defective and considered production yield loss. Due to the recent demand for electronic components with a higher degree of integration and miniaturization, (compared with conventional electronic components), it is required that the static electricity generation be suppressed to a greater extent during the manufacturing processes for treating these components, compared with the conventional technology. Japanese laid open (Kokai) patent No. 2000-216215 discloses a transfer member made of fiber-reinforced carbon composite materials, upon which the semiconductor wafer or liquid crystal substrate is placed and the transfer member surface is coated with metal to prevent particles such as carbon powders from scattering.

In general, there are two common methods to remove static electricity: 1) discharging the static electricity by grounding (i.e. the grounding method) and 2) neutralizing the static electricity by generating ions in the atmosphere (i.e. the ion neutralizing method). The prior art discloses the use of insulative material which precludes the use of the grounding method. For example, Japanese laid open (Kokai) patent No. 9-36207 discloses the technology of using carbon contained polyimide polymer in forming a finger in which a substrate is placed upon. Another example includes, the Japanese published (Kohyo) No. 10-509747 which discloses a carrier of anti-abrasive composite material comprising base polymer selected from polyolefin and polyamide and milled carbon fiber fillers having particular average fiber diameter. In addition, Japanese laid open (Kokai) patent No.11-106665 discloses a transfer member formed of thermoplastic polymer having predetermined surface resistivity and fibrous conductive fillers having predetermined volume resistivity.

In components held and transferred by the transfer member of an insulator, such as plastics and ceramics, the grounding method cannot be used. Thus, to remove the static electricity of the components transferred by the transfer member, such as CFRP, only the ion neutralizing method is applied. However, the ion neutralization method may also be problematic. Electromagnetic noise, fine particles, and ozone are sometimes generated from the apparatus used to generate ions for neutralization, creating the possibility that these generated elements will have a negative influence on the manufacturing processes. Also, in the ion neutralizing method, a bias consisting of the amount of cations and anions is sometimes generated, and there is also a possibility that additional static electricity will be generated.

It is desirable to have methods, other than the ion neutralizing method, for the development of methods for removing electric charge generated in the components transferred by the transfer part of an insulator such as CFRP.

### SUMMARY OF THE INVENTION

Briefly stated, and in accordance with one aspect of the present invention, there is provided a transfer member for transferring at least one article comprising a body having a carbon-fiber-reinforced composite material and an electroconductive polymer part disposed on said body, said electroconductive polymer part having a portion for an article contact with the at least one article during transfer of the at least one article, said electroconductive polymer part being electrically connected to an at least part of the carbon fibers of the carbon-fiber-reinforced composite material in said body.

Pursuant to another aspect of the present invention, there is provided a manufacturing method of the transfer member for transferring at least one article, comprising a body having a carbon-fiber-reinforced composite material and an electroconductive polymer part disposed on said body, comprising:
a) preparing a body containing a carbon-fiber-reinforced composite material;
b) exposing at least part of the carbon fibers of the carbon-fiber-reinforced composite material of said body; and
c) disposing an electroconductive polymer part onto said body such that the at least part of the carbon fibers being exposed are electrically connected to the electroconductive polymer part.

### BRIEF DESCRIPTION OF THE DRAWINGS

The invention will be more fully understood from the following detailed description, taken in connection with the accompanying drawings, in which:
Figure 1 is a vertical sectional view showing an example of the transfer part of the present invention.
Figure 2 is a vertical sectional view showing another example of the transfer part of the present invention.
Figure 3 is a top view showing another example of the transfer part of the present invention.
Figure 4 is a top view showing another example of the transfer part of the present invention.

While the present invention will be described in connection with a preferred embodiment thereof, it will be understood that it is not intended to limit the invention to that embodiment. On the contrary, it is intended to cover all alternatives, modifications, and equivalents as may be included within the spirit and scope of the invention as defined by the appended claims.

### DETAILED DESCRIPTION OF THE INVENTION

### Definitions:

The following definitions are provided as reference in accordance with how they are used in the context of this specification and the accompanying claims.
1.**Body** - A transfer member that has a portion that holds the article being transferred.
2. **Prepeg -** Dry fabric wet with a resin solution such that the resin impregnates the dry fabric.
3. **M6 -** is the metric nominal diameter of a 6 mm tapped hole.

A key element of the present invention is the unique pitch based carbon fibers. By combining the unique pitch based carbon fibers with select epoxy polymers, the present invention provides a variety of modulus (e.g. 100GPa to over 250 GPa) and temperature capability (e.g.100C to over 230C) and a high purity sealant option.

The present invention discloses a lightweight transfer member with high stiffness, heat resistance and chemical resistance, that improves transferability of a transferred article. For example, a silicon wafer for a semiconductor and a liquid crystal glass substrate moved by the transfer member of the present invention, will suppress damage to the transferred articles caused by the transferring environment and effectively remove the static electricity of the transferred article using the grounding method. The present invention allows the use of the grounding method in contrast to the prior art methods which only use the ion neutralization method.

The present invention has a transfer member for transferring an article, that is equipped with a transfer member body containing a carbon-fiber-reinforced composite material and an electroconductive polymer installed on the body. The carbon-fiber-reinforced composite material of the transfer member body includes at least one layer of a unidirectional prepreg in which carbon fibers are arranged essentially parallel with the longitudinal direction of the body. The carbon-fiber-reinforced composite material of the body includes at least one layer of a cloth prepreg containing carbon fibers, with at least part of the carbon fibers of the prepreg and the electroconductive polymer part being electrically connected.

The carbon-fiber-reinforced composite material of the transfer member includes: a carbon-fiber-reinforced plastic (CFRP) and a carbon-fiber-reinforced carbon composite material (C/C composite material). The CFRP material is preferred. The matrix material of the carbon-fiber-reinforced composite material comprises: a thermosetting polymer, a thermoplastic polymer, carbon, ceramic, metal, and mixtures thereof. In the present invention, a thermosetting polymer, carbon, or a mixture thereof is preferable as the matrix. A thermosetting polymer includes: an epoxy, aramid, bismaleimide, phenol, furan, urea, unsaturated polyester, epoxy acrylate, diallyl phthalate, vinyl ester, thermosetting polyimide, melamine, and other such materials.

The thermoplastic polymer matrix material for the present invention includes: polyimide resin, nylon, liquid aromatic polyamide, polyester, liquid aromatic polyester, polypropylene, polyether sulfone polymer, polyphenylene sulfide, polyether ether ketone, PEK, PEKK, LCP, polysulfone, polyvinyl chloride, vinylon, aramid, fluoropolymer, and other such materials. The ceramic matrix material for the present invention includes: alumina, silica, titanium carbide, silicon carbide, boron nitride, silicon nitride, and other such materials. Metal matrix materials for the present invention include: titanium, aluminum, tin, silicon, copper, iron, magnesium, chromium, nickel, molybdenum, tungsten, and alloys containing one or more of these metals.

The carbon fibers included in the above-mentioned carbon-fiber-reinforced composite material comprise: petroleum pitch-type carbon fibers, coal pitch-type carbon fibers, polyacrylonitride (PAN) carbon fibers, and other such fibers. The electric resistivity of the carbon fibers is normally from 1-30µ Ω·m, and preferably 1-20 Ω·µm. The carbon-fiber-reinforced composite material may include only one kind of carbon fibers and can also include a hybrid structure of two or more kinds of these carbon fibers.

The form of the carbon fibers used in the carbon-fiber-reinforced composite material include one-dimensional reinforcing, two-dimensional reinforcing, three-dimensional reinforcing, random reinforcing, and similar forms are appropriately selected and adopted in accordance with the desired purpose of the transfer member. For example, the carbon fibers may be in the form of short fibers, woven fabric, nonwoven fabric, unidirectional material, two-dimensional woven fabric, and three-dimensional woven fabric as desired. More specifically, the carbon fibers may be used in a material with the structure of felt, mat, braided fabric (i.e. nonwoven fabric comprising carbon fibers arranged in parallel crosses or triangular form with hot-melt polymer), unidirectional material, pseudo-isotropic material, plain fabric, satin, twilled fabric, pseudo thin fabric, entangled fabric, etc., is laminated and can be installed in the above-mentioned carbon-fiber-reinforced composite material.

The electroconductive polymer part is electrically connected to at least part of the carbon fibers in the body. The body makes contact with the article when the article is transferred. A portion of the electroconductive polymer part is in contact with the transferred article placed thereon. The contact, between the article and the body, is electrically connected to the electroconductive polymer part via the carbon fibers. The present invention further provides contact to a grounding conductor.

The electroconductive polymer part includes a polyimide polymer. In the present invention, the polymer material has electric conductivity. For example, a polymer material in which an electroconductive filler is added to a thermosetting or thermoplastic polymer. Other materials for the above-mentioned polymer material include: a fluoropolymer, PEEK, PEKK, PEK, polyacetate, nylon polymer, aromatic polyimide, polyethersulfon, polyimide, polyetherimide, polyamideimide, polyester, liquid crystal polymer, polybenzimidazole, Poly(paraphenylene benzobisaxazole) (PBO), polyphenylene sulfide, polycarbonate, polyacrylate, polyacetal, or mixture of two or more thereof. Other electroconductive fillers for use in the present invention include: metal powders, carbon black, carbon fibers, zinc oxide titanium oxide, potassium titanate. It is preferable, in the present invention, that the polymer material contain a polyimide that has excellent abrasive resistance, antistatic property and chemical resistance; has dimensional stability and mechanical processability for manufacturing a transfer member; and does not easily damage articles such as glass substrates or wafers when making contact with them; and does not easily generate particles.

In the present invention, the volume resistivity of the electroconductive polymer part normally ranges from 10¹-10¹² Ω·cm, and preferably from 10⁴-10⁵ Ω·cm.

Additionally, the present invention provides a manufacturing method for making the transfer member which includes preparing a transfer member body containing a carbon-fiber-reinforced composite material. The process exposes a portion of the carbon fibers of the composite material, and an electroconductive polymer part is installed on the transfer member body such that it can be electrically connected to the exposed carbon fibers. The electroconductive polymer part is installed by bonding the transfer member body and the electroconductive polymer part with an electroconductive adhesive. The manufacturing method for installation of the electroconductive polymer part comprises inserting the electroconductive polymer part into a hole or concave part. The hole and concave part are formed in a way to expose the internal carbon fibers of the composite material.

Another aspect of the present invention is the method of manufacturing a transfer member with electric conductivity. A method for manufacturing the carbon-fiber-reinforced composite material such as CFRP and C/C composite material known in the art can be used. For example, the CFRP can be prepared by forming a prepreg by impregnating reinforcing carbon fibers with a thermosetting polymer, then laminating and curing them. However, it is preferable to obtain the CFRP with a prescribed elastic modulus by laminating the prepreg of unidirectional reinforcing carbon fibers, that is, unidirectional prepreg so that the direction of the fibers is 0° and 90°, 0°, ± 45°, and 90° or 0°, ± 60°, and 90° with respect to the longitudinal direction of the transfer part.

In the impregnation of the reinforcing carbon fibers into the thermosetting polymer, a hot-melt method, that usually heats the polymer to 60-90°C and impregnates it on the reinforcing fibers, is preferably applied. The content of the thermosetting polymer in the prepreg manufacture is usually 20-50 wt%, and preferably 25-45 wt%, relative to the total weight of the reinforcing fibers.

If necessary, a filler can be added to the polymer constituting the prepreg. The filler material includes: mica, alumina, talc, fine powder-shaped silica, wollastonite, sepiolite, basic magnesium sulfate, calcium carbonate, polytetrafluoroethylene powder, zinc powder, aluminum powder, and organic fine particles such as fine acryl particles, fine epoxy polymer particles, fine polyamide particles, and fine polyurethane particles and other such materials. The prepreg is laminated in an appropriate shape on the transfer part and heated and cured at 110-150°C for 30 min-3 hr in an autoclave or by a press, so that the CFRP can be obtained. With such a method, CFRP with stable qualities and little voids can be obtained.

The C/C composite material can also be manufactured by a known method. For example, carbon fibers are used in a form similar to the carbon fibers used for the CFRP manufacture described above. A preform (i.e a shape formed at an intermediate step of the process) is formed by impregnating the preform into a matrix polymer such as a thermoplastic polymer and thermosetting polymer, then carbonized by a hot isostatic process (i.e. HIP) treatment or similar method so that the carbonized matrix can be formed on the carbon fibers. Carbonization can be carried out by heating the preform as described above at ,500°C, preferably,300°C, in an inert gas.

The C/C composite includes a pitch substance such as those using coal pitch, petroleum pitch, synthetic pitch, isotropic pitch, and meso-phase pitch as raw materials. Also a thermoplastic polymer that may include: polyimide resin, phenol polymer, epoxy polymer, furan polymer and urea polymer and a thermosetting polymer comprises phenol polymer, epoxy polymer, furan polymer, urea polymer and other such materials.

The pitch, thermosetting polymer, or thermoplastic polymer can also be mixed with a filler and provided to the process for forming the matrix. Examples of filler material include: carbon powders, graphite powders, silicon carbide powders, silica powders, carbon fiber whiskers, carbon short fibers, and silicon carbon short fibers.

Another example of the method for manufacturing the C/C composite material, is forming a matrix by attaching a thermally decomposable carbon to carbon fibers using chemical vapor deposition (CVD), chemical vapor infiltration (CVI), or such similar process creating the C/C composite material can be prepared. The C/C composite material obtained in this manner can be further subjected to a miniaturization treatment. In particular, the density of the composite material can be improved by repeating the matrix forming process.

The body of the transfer member of the present invention may be formed from just the carbon-fiber-reinforced composite material or, from the combination of the carbon-fiber-reinforced composite fiber and other materials such as a glass fiber reinforced plastic (GFRP). The other materials include structures such as a honeycomb, a porous body, or a corrugated plate.

The carbon-fiber-reinforced composite material of the transfer member comprises a purity of less than 15 ppm water and less than 1 ppm hydrogen gas being evolved at a vacuum of 10⁻⁵ Pa, having a temperature condition of from 25°C to 250°C at a ramp up rate of 10°C/minute.

The body can be prepared by subjecting the molded body, containing the carbon-fiber-reinforced composite material obtained using the method described above, to a process such as cutting the body to the desired shape. With such processing, the body having the desired form can be obtained with accurate working precision. Furthermore, an electrical connection of the carbon fibers and the electroconductive polymer part can be easily achieved as will be described subsequently. And, if necessary, the body can have coating agents applied to prevent particle generation from the working surface. A thermosetting polymer such as an epoxy polymer and silicone wax can be used as the coating agent.

An example of the transfer member body of the present invention is an oblong plate-shaped structure with skin layers positioned on both surfaces of the plate and a core layer positioned between the skin layers. The skin layers have a first carbon-fiber-reinforced composite material layer containing carbon fibers, that are oriented at an angle of -20° to +20° with respect to the longitudinal direction of the transfer part and have a tensile elastic modulus of 500-1,000 Gpa. The second layer is a carbon-fiber-reinforced composite material layer containing carbon fibers, that are oriented at an angle of +75° to +90° and/or -75° to -90° with respect to the longitudinal direction of the transfer part and have a tensile elastic modulus of 200-400 GPa. The skin layers have a third carbon-fiber reinforced composite fiber that is oriented at an angle of +30° to +60° and/or -30° to -60° with respect to the longitudinal direction of the transfer part and has a tensile elastic modulus of 500-1,000 GPa. The ratio of the thickness of the three skin layers to the total thickness of the skin layers and the core layer is 20-80%, preferably 60-80%. The contact can be electrically connected to the polymer electroconductive part via carbon fibers of the skin layers. Also the core layer, in addition to or instead of, the above-mentioned third skin layer of carbon-fiber-reinforced composite material, may include another material layer with a structure such as a honeycomb, porous body, and/or a waved plate (corrugated) and voids may also be used. A cloth layer made of fiberous materials such as carbon fibers, can be disposed on the outermost surface of the body making it easier to process the transfer members than if the cloth layer was not present. And, if the cloth layers are made of carbon fiber, the electronic connection between the contact and electroconductive polymer part becomes easier.

The transfer member of the present invention comprises a body having a carbon-fiber-reinforced composite material and an electroconductive polymer part being electrically connected to at least part of the carbon fibers in the body and having a portion for contact with a transferred article by placing it on the body. The area where the transfer member makes contact with the article may be the surface of the distal end of the transfer member, and the electroconductive polymer part.

In the transfer member of the present invention, the electrical connection of the electroconductive polymer part with at least part of the carbon fibers of the body can be achieved by: preparing the body containing the carbon-fiber-reinforced composite material, exposing the part of the carbon fibers of the composite material, and installing the electroconductive polymer part on the body so that it can be electrically connected with the carbon fibers exposed. Exposing the carbon fibers may be obtained by forming the transfer member body as a molded body containing the carbon-fiber-reinforced composite material and forming a hole or concave part by cutting a portion thereof. (e.g. Normally, when a molded body containing a carbon-fiber-reinforced composite material is manufactured, its surface is coated with a matrix, and the carbon fibers are not exposed. Thus, if a portion of the body is cut, the carbon fibers are exposed.)

The electrical connection of the exposed carbon fibers and the electroconductive polymer part may occur by bonding the body and the electroconductive polymer part with an electroconductive adhesive at a different portion of the electroconductive polymer part then the portion for contact with a transferred article on the surface of the body containing the cut surface or by inserting the electroconductive polymer part into the hole or concave part formed in the process for exposing the carbon fibers of the body. However, a method for bonding the body and the electroconductive polymer part is not critical, any method in which the electroconductive polymer part can be electrically connected with at least part of the carbon fiber forming the body and another portion where a transferred article may be placed in contact therewith may be used.

The transfer part of the present invention may be equipped with only one electroconductive polymer part or with several electroconductive polymer parts. When several electroconductive polymer parts are used, one or more of them can be electrically connected to the carbon fibers.

The transfer part of the present invention can be further equipped with a contact to a grounding conductor. The above-mentioned contact is electrically connected with the electroconductive polymer part via at least part of the carbon fibers, so that the static electricity of an article making contact with the electroconductive polymer part can be removed by the grounding method. The above-mentioned contact may be simply that of the exposed surface of the carbon fibers formed by cutting of the body or it may also be a desired metal electrode.

The shape of the transfer part of the present invention can be oblong as mentioned above, however, a variety of shapes including a plate shape, rod shape, fork shape, honeycomb shape, hollow rod shape, T shape, I shape, curved surface shape, or a combined shape can also be adopted for use in the present invention. Typically, the transfer member of the present invention can have an area in contact with the transferred article at its distal end or can have the contact at its proximal end. The transfer member of the present invention may have a shape in which only the electroconductive polymer part makes contact with the transferred article and supports it or, a shape in which both the electroconductive polymer part and the body make contact with the transferred article and support it. The proximal end is fixed to a device for moving the transfer member such as an industrial robot. The device is operated such that the article being transferred may be placed or held at the distal end to enable transfer of the article.

Reference is now made to the drawings for a detailed description of the present invention. Examples of the transfer part of the present invention are explained below in reference to the figures.

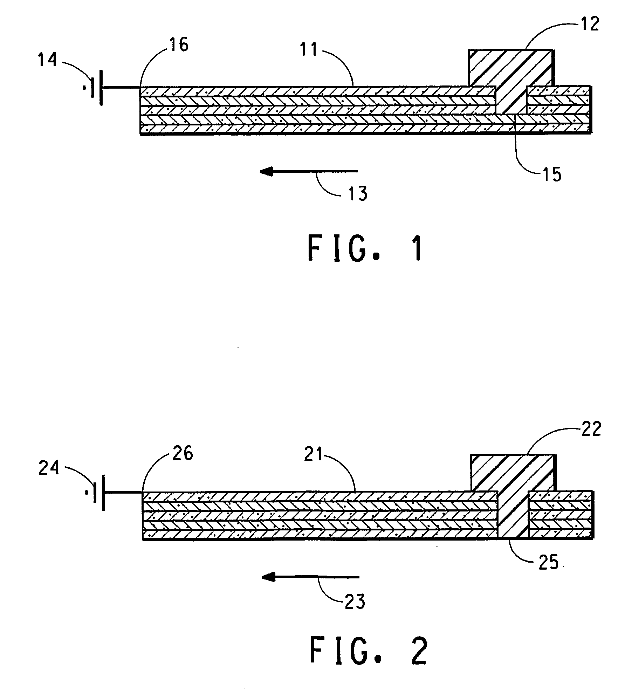

Figure 1 shows an example of the transfer member of the present invention. Figure 1 is a cross section in which the transfer member is cut by a vertical section, including its longitudinal direction. A body 11 has an oblong plate shape, and is formed of a carbon-fiber-reinforced composite material, and has a concave part 15 on the upper surface of its distal end. The concave part 15 is produced by forming a molded body composed of a carbon-fiber-reinforced composite material and cutting it in the shape shown. An electroconductive polymer part 12 has a convex part fitting into the concave part 15 and is mounted in the body 11 via an electroconductive adhesive or by press-feeding it into the concave part 15. At the proximal end of the body 11, a contact 16 to a grounding conductor 14 is installed and connected to the grounding conductor 14. In actual use, the contact 16 may be directly connected to the grounding conductor 14 or may also be grounded via a device such as an industrial robot for moving the transfer member. The contact 16 can also have a structure fitted to each ground shape. The body 11 is formed by laminating unidirectional prepreg sheets. In the body 11, part or all of the carbon fibers are arranged substantially parallel with the longitudinal direction of the body 11, that is, in the distal position toproximal position direction. Thus, the electroconductive polymer part 12 and the contact 16 are electrically connected via the carbon fibers of the body 11, and in transferring an article, the article makes contact with the electroconductive polymer part 12, so that a current flows in the arrow 13 direction, thereby removing the current.

Reference is now made to Figure 2, which shows a vertical sectional view of another example of the transfer part of the present invention. In a transfer member body 21, a hole 25, penetrating in the thickness direction into the body 21 is formed, and an electroconductive polymer part 22 with a shape fitting to the hole 25 is mounted. The grounding conductor 24 is connected to the contact 26 in a similar manner as described in Figure 1. The electroconductive polymer part 22 is electrically connected to a contact 26 via carbon fibers arranged substantially parallel with the longitudinal direction of the body 21, that is, in the distal position-proximal position direction in the body 21. Thus, in transferring an article, the article makes contact with the electroconductive polymer part 22, so that a current flows in the direction of arrow 23, thereby removing the current (i.e. discharging the static electricity).

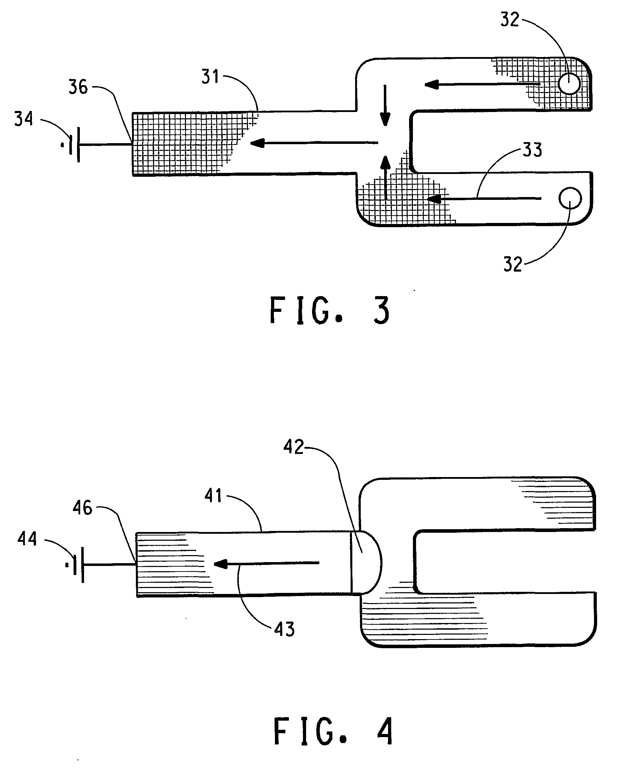

Reference is now made to Figure 3, which shows a top view of an example of the transfer member of the present invention. A body 31 has a fork-shaped structure, and an electroconductive polymer part 32 is mounted in each of its branched ends. The body 31 is formed by laminating cloth prepreg sheets. In the body 31, carbon fibers in the cloth prepregs are crossed and extended in the longitudinal direction and the width direction of the transfer member body 31. Therefore, the electroconductive polymer part 32 is electrically connected to a contact 36 via said carbon fibers, and in transferring an article, the article makes contact with the electroconductive polymer part 32, so that a current flows in the arrow direction 33, thereby removing the current (i.e. discharging the static electricity). The grounding conductor 34 is connected to the contact 36 in a similar manner as described in Figure 1.

Reference is now made to Figure 4, which shows a top view showing another example of the transfer member of the present invention. The body 41 has a fork-shaped structure. In the body 41, part or all of the carbon fibers are arranged essentially parallel with the longitudinal direction, that is, the distal position-proximal position direction of the body 41. An electroconductive polymer part 42 is mounted at a position shown in Figure 4, so that it is electrically connected to a contact 46 via the *carbon fibers.* The grounding conductor 44 is connected to the contact 46 in a similar manner as described in Figure 1. Thus, in transferring an article, the article makes contact with the electroconductive polymer part 42, so that a current flows in the arrow direction 43, thereby removing the current (i.e discharging the static electricity).

The transfer member of the present invention comprises a body comprising a carbon-fiber-reinforced composite material and an electroconductive polymer part being electrically connected to at least part of the carbon fibers in said body and having a portion for contact with a transferred article by it being placed on, can improve transferability of a transferred article such as silicon wafer for semiconductor and liquid crystal glass substrate by a transfer member, suppress damage to the transferred articles caused by a transferring environment and be easily manufactured, and has lightness, high stiffness, and high heat resistance due to the body containing a fiber reinforced composite material and the electroconductive polymer part associated with the body, in addition, can effectively remove the static electricity of an article by the grounding method. Therefore, components such as large-scale glass substrates and wafers, which require an accurate operation, can be favorably transferred without lowering their qualities and yield. Thus, the transfer part is very useful in the manufacturing processes of equipment such as precision equipment. Also, in the method for manufacturing the transfer member of the present invention, the above-mentioned transfer part can be manufactured in a simple manner.

### EXAMPLES

The following application examples and comparative examples are provided to further explain the invention and is not intended to limit the present invention to the examples described.

### EXAMPLE 1

A transfer member incorporating an electroconductive polymer part and a body made of CFRP was manufactured. First, a skin layer was prepared using a pitch carbon fiber Pitch-type carbon fibers with a tensile elastic modulus of 800 GPa were unidirectionally pulled, aligned, and impregnated with an epoxy polymer, so that unidirectional prepreg sheets were prepared. Several prepregs were laminated so that the direction of the carbon fibers was 0° (that is, the same direction), with respect to the longitudinal direction of the transfer part. The sheet laminated was treated in an autoclave, so that a skin layer with a thickness of about 1.3 mm was manufactured.

Next, the core layer was manufactured. Pitch-type carbon fibers with a tensile elastic modulus of 600 GPa were unidirectionally pulled, aligned, and impregnated with an epoxy polymer, so that unidirectional prepreg sheets were prepared. Several prepregs were laminated so that the direction of the carbon fibers was 90° with respect to the longitudinal direction of the transfer part. The laminated sheet was treated in an autoclave, so that a core layer with a thickness of about 1.5 mm was manufactured.

Next the body is manufactured from CFRP. The core layer described above was disposed between two sheets of skin layers described above and adhered with conductive thermosetting adhesive, so that a laminate having the skin layers on the upper and lower surfaces and the core layer between them was obtained. On the surfaces of two skin layers, a woven fabric prepeg (satin, about 0.1 mm in thickness) of carbon fibers with a tensile elastic modulus of 230 GPa was adhered to form a cloth layer then heated under pressure, thereby obtaining a CFRP plate. A M6 tap hole for installation was formed in the CFRP plate, so that a body with a length of 600 mm, a width of 240 mm, and a thickness of 4.3 mm was formed.

Next, the transfer member is manufactured. At the distal end of the upper surface of the CFRP body (manufactured as described above), three holes with an inner diameter of 3 mm penetrating in the thickness direction were formed. Three pads made of an electroconductive polymer with a volume resistivity of 10⁴ Ω·cm, which had concave parts fitting to these holes and which included a polyimide polymer (Vespel® SP-102 available from DuPont), were installed in each of these holes by press-feeding them, so that a transfer member was created.

### EXAMPLE 2

The first three steps of Example 1 apply to this example. Next, an alternate embodiment of the transfer member was then manufactured. At the distal end of the upper surface of the body formed in Example 1, three holes with an inner diameter of 3 mm and a depth of 1 mm were formed. Three pads made of an electroconductive polymer with a volume resistivity of 10⁴ Ω·cm, which had concave parts fitting to these holes and which included a polyimide polymer (Vespel® SP-102 available from DuPont), were installed by press-feeding them into each of these holes, so that a transfer member was created.

### EXAMPLE 3

### DE-ELECTRIFICATION TEST OF STATIC ELECTRICITY

The transfer members obtained in Examples 1 and 2 were respectively installed in a transfer device, then the transfer members were grounded. Next, a silicon wafer with a diameter of about 300 mm, which was an article being transferred, was charged at about 2 kV using a power source for a forced charging. Next, the charged silicon wafer was placed so that it could make contact with three polymer pads of the transfer members, then held for about a 3 second time period so that the voltage charge could dissipate through the electroconductive transfer member. The charged voltage of the wafer was then measured by an electrostatic voltage meter (by Shishido Electrostatics, Ltd. Model STATIRON DZ3) to verify the function of the electroconductive transfer member. The voltage meter measured that the voltage charge of the wafer dissipated to a value of less than 200 Volts after contact with the transfer member for three (3) seconds confirming that the removal of static electricity was effectively carried out.

### COMPARATIVE EXAMPLE

A transfer member was made of ceramic in this comparative example. An M6 tap hole was formed in an aluminum plate with a length of 600 mm, a width of 240 mm, and a thickness of 4.3 mm, so that a body was created. Similarly to Example 1 and 2 described above, three pads made of an electroconductive polymer, which included a polyimide polymer and had a volume resistivity of 10⁴ Ω·cm, were installed in the body, so that transfer members were formed. These transfer members were subjected to a test to determine if the static electricity is removed similarly to Example 3 described above. In contrast to Example 3, it was confirmed that the charged voltage of the silicon wafer seldom changed before and after the test, and that the static electricity could not be removed after a three (3) second measurement and remained at a value greater than 1600 Volts. (The voltage was measured using a Shishido Electrostatics, Ltd. Model STATIRON DZ3 electrostatic voltage meter.)

It is therefore, apparent that there has been provided in accordance with the present invention, a transfer member with electric conductivity and its manufacturing method, that fully satisfies the aims and advantages hereinbefore set forth. While this invention has been described in conjunction with a specific embodiment thereof, it is evident that many alternatives, modifications, and variations will be apparent to those skilled in the art. Accordingly, it is intended to embrace all such alternatives, modifications and variations that fall within the spirit and broad scope of the appended claims.

## Claims

1. A transfer member for transferring at least one article in manufacturing processes of precision machines such as liquid-crystal display devices and semiconductors, the said transfer member comprising:
a body having a carbon-fiber-reinforced composite material;
**characterized by** an electroconductive polymer part disposed on said body, said electroconductive polymer part having a portion for contact with the at least one article during transfer of the at least one article, and said electroconductive polymer part being electrically connected to an at least part of the carbon fibers of the carbon-fiber-reinforced composite material in said body.

2. The transfer member of **Claim 1,** wherein said carbon-fiber reinforced composite material comprises a purity of less than 15 ppm water and less than 1 ppm hydrogen gas being evolved at a vacuum of 10⁻⁵ Pa, having a temperature condition of from 25°C to 250°C at a ramp up rate of 10°C/minute.

3. The transfer member of **Claim 1 or 2,** wherein said body has a proximal end to which a grounding contact to a grounding conductor is provided, and said article contact being electrically connected to said electroconductive polymer part by said at least part of the carbon fibers.

4. The transfer member of **Claim 1 or 3,** wherein said carbon-fiber-reinforced composite material of said body comprises at least one layer of a unidirectional prepreg having carbon fibers arranged substantially parallel with a longitudinal direction of said body, and at least part of the carbon fibers of said unidirectional prepreg and said electroconductive polymer part being electrically connected.

5. The transfer member of **Claim 1 or 3,** wherein said carbon-fiber-reinforced composite material of said body comprises at least one layer of a cloth prepreg containing carbon fibers and at least part of the carbon fibers of said prepreg and said electroconductive polymer part being electrically connected.

6. The transfer member of any of **Claims 1- 5,** wherein said electroconductive polymer part comprises one or more of: a polyimide, epoxy, aramid, bismaleimide, phenol, furane, urea, unsaturated polyester, epoxy acrylate, diallyl phthalate, vinyl ester, melamine, nylon polymer, liquid aromatic polyamide polymer, polyester polymer, liquid aromatic polyester polymer, polypropylene polymer, polyether sulfone polymer, polyphenylene sulfide polymer, polyether ether ketone polymer, poly ether ketone polymer, poly ether ketone polymer, polysulfone polymer, polyvinyl chloride polymer, vinylon polymer, aramid polymer, liquid crystal polymer, Poly(paraphenylene benzobisaxazole) or fluoropolymer.

7. A manufacturing method of the transfer member of any of **Claims 1-6,** comprising:
a) preparing a body containing a carbon-fiber-reinforced composite material;
b) exposing at least part of the carbon fibers of the carbon-fiber-reinforced composite material of said body; and
c) disposing an electroconductive polymer part onto said body such that the at least part of the carbon fibers being exposed are electrically connected to the electroconductive polymer part.

8. The manufacturing method of **Claim 7,** wherein said electroconductive polymer part is disposed upon said body using an electroconductive adhesive.

9. The manufacturing method of **Claim 7,** wherein the disposing step comprises inserting said electroconductive polymer part into a defined aperture or a concave part formed for exposing at least part of the carbon fibers.

## Patentansprüche

1. Transportelement für den Transport mindestens eines Gegenstands in Herstellungsverfahren von Präzisionsgeräten, wie z.B. Flüssigkristallanzeigegeräte und Halbleiter, wobei das Transportelement aufweist:
einen Körper mit einem kohlefaserverstärkten Verbundstoff;
**gekennzeichnet durch** ein auf dem Körper angeordnetes, elektrisch leitendes Polymerteil, wobei das elektrisch leitende Polymerteil einen Abschnitt für den Kontakt mit dem mindestens einen Gegenstand während des Transports des mindestens einen Gegenstands aufweist, und wobei das elektrisch leitende Polymerteil mit mindestens einem Teil des kohlefaserverstärkten Verbundstoffs in dem Körper elektrisch verbunden ist.

2. Transportelement nach Anspruch 1, wobei der kohlefaserverstärkte Verbundstoff eine Reinheit von weniger als 15 ppm Wasser aufweist, und wobei in einem Vakuum von 10⁻⁵ Pa mit einem Temperaturzustand von 25°C bis 250°C bei einer Anstiegsgeschwindigkeit von 10°/Minute weniger als 1 ppm Wasserstoffgas entwickelt wird.

3. Transportelement nach Anspruch 1 oder 2, wobei der Körper ein proximales Ende aufweist, an dem ein Massekontakt zu einem Erdungsleiter vorgesehen ist, und wobei der Kontakt des Gegenstands durch mindestens einen Teil der Kohlefasern mit dem elektrisch leitenden Polymerteil elektrisch verbunden ist.

4. Transportelement nach Anspruch 1 oder 3, wobei der kohlefaserverstärkte Verbundstoff des Körpers mindestens eine Schicht aus einem einseitig gerichteten vorimprägnierten Glasfasermaterial mit im wesentlichen parallel zu einer Längsrichtung des Körpers angeordneten Kohlefasern aufweist, und wobei zumindest ein Teil der Kohlefasern des einseitig gerichteten vorimprägnierten Glasfasermaterials und das elektrisch leitende Polymerteil elektrisch miteinander verbunden sind.

5. Transportelement nach Anspruch 1 oder 3, wobei der kohlefaserverstärkte Verbundstoff des Körpers mindestens eine Schicht aus einem vorimprägnierten Glasfasergewebe aufweist, das Kohlefasern enthält, und wobei zumindest ein Teil der Kohlefasern des vorimprägnierten Gewebes und das elektrisch leitende Polymerteil elektrisch miteinander verbunden sind.

6. Transportelement nach einem der Ansprüche 1 - 5, wobei das elektrisch leitende Polymerteil eine oder mehrere der folgenden Verbindungen aufweist: ein Polyimid, Epoxidharz, Aramid, Bismaleimid, Phenol, Furan, Harnstoff, ungesättigten Polyester, Epoxyacrylat, Diallylphthalat, Vinylester, Melamin, Nylonpolymer, flüssiges aromatisches Polyamid-Polymer, Polyester-Polymer, flüssiges aromatisches Polyester-Polymer, Polypropylen-Polymer, Polyethersulfon-Polymer, Polyphenylensulfid-Polymer, Polyetheretherketon-Polymer, Polyetherketon-Polymer, Polysulfon-Polymer, Polyvinylchlorid-Polymer, Vinylon-Polymer, Aramid-Polymer, Flüssigkristallpolymer, Poly(paraphenylenbenzobisaxazol) oder Fluorpolymer.

7. Fertigungsverfahren für das Transportelement nach einem der Ansprüche 1 - 6, das aufweist:
a) Herstellen eines Körpers, der einen kohlefaserverstärkten Verbundstoff enthält;
b) Freilegen zumindest eines Teils der Kohlefasern des kohlefaserverstärkten Verbundstoffs des Körpers; und
c) Anbringen eines elektrisch leitenden Polymerteils auf dem Körper, so daß zumindest ein Teil der freiliegenden Kohlefasern elektrisch mit dem elektrisch leitenden Polymerteil verbunden wird.

8. Fertigungsverfahren nach Anspruch 7, wobei das elektrisch leitende Polymerteil unter Verwendung eines elektrisch leitenden Klebstoffs auf dem Körper angebracht wird.

9. Fertigungsverfahren nach Anspruch 7, wobei der Anbringungsschritt das Einsetzen des elektrisch leitenden Polymerteils in eine definierte Öffnung oder ein konkaves Teil aufweist, das geformt wird, um zumindest einen Teil der Kohlefasern freizulegen.

## Revendications

1. Elément de transfert pour transférer au moins un article dans des procédés de fabrication de machines de précision, telles que des dispositifs d'affichage à cristaux liquides et des semi-conducteurs, ledit élément de transfert comprenant:
un corps qui comporte un matériau composite renforcé par fibres de carbone,
**caractérisé par** une partie en polymère électroconducteur qui est disposée sur ledit corps, ladite partie en polymère électroconducteur comportant une portion pour un contact avec l'au moins un article pendant un transfert de l'au moins un article; et ladite partie en polymère électroconducteur qui est connectée électriquement à au moins une partie des fibres de carbone du matériau composite renforcé par fibres de carbone dans ledit corps.

2. Elément de transfert selon la revendication 1, dans lequel ledit matériau composite renforcé par fibres de carbone démontre une pureté de moins de 15 ppm d'eau et une évolution de gaz hydrogène de moins de 1 ppm sous un vide de 10⁻⁵ Pa, dans une condition de température comprise entre 25°C et 250°C avec une vitesse de montée de température de 10°C/minute.

3. Elément de transfert selon la revendication 1 ou 2, dans lequel ledit corps comporte une extrémité proximale sur laquelle un contact de mise à la masse sur un conducteur de mise à la masse est prévu, et ledit contact d'article est connecté électriquement à ladite partie en polymère électroconducteur par au moins ladite partie des fibres de carbone.

4. Elément de transfert selon la revendication 1 ou 3, dans lequel ledit matériau composite renforcé par fibres de carbone dudit corps comprend au moins une couche d'un pré-imprégné unidirectionnel comportant des fibres de carbone agencées sensiblement parallèlement à une direction longitudinale dudit corps, et au moins une partie des fibres de carbone dudit pré-imprégné unidirectionnel et ladite partie en polymère électroconducteur sont connectées électriquement.

5. Elément de transfert selon la revendication 1 ou 3, dans lequel ledit matériau composite renforcé par fibres de carbone dudit corps comprend au moins une couche d'un pré-imprégné de tissu contenant des fibres de carbone, et au moins une partie des fibres de carbone dudit pré-imprégné et ladite partie en polymère électroconducteur sont connectées électriquement.

6. Elément de transfert selon l'une quelconque des revendications 1 à 5, dans lequel ladite partie en polymère électroconducteur comprend un ou plusieurs éléments pris parmi: un polyimide, époxy, aramide, bismaléimide, phénol, furane, urée, polyester non saturé, acrylate d'époxy, phtalate de diallyle, ester de vinyle, mélamine, polymère de nylon, polymère de polyamide aromatique liquide, polymère de polyester, polymère de polyester aromatique liquide, polymère de polypropylène, polymère de sulfone de polyéther, polymère de sulfure de polyphénylène, polymère de polyéther éther cétone, polymère de polyéther cétone, polymère de polysulfone, polymère de chlorure de polyvinyle, polymère de vinylon, polymère d'aramide, polymère de cristaux liquides, poly(paraphénylène benzobisaxazole) ou fluoropolymère.

7. Procédé de fabrication de l'élément de transfert selon l'une quelconque des revendications 1 à 6, comprenant:
a) la préparation d'un corps qui contient un matériau composite renforcé par fibres de carbone;
b) l'exposition d'au moins une partie des fibres de carbone du matériau composite renforcé par fibres de carbone dudit corps; et
c) la disposition d'une partie en polymère électroconducteur sur ledit corps de telle sorte que l'au moins une partie des fibres de carbone qui est exposée soit connectée à ladite partie en polymère électroconducteur.

8. Procédé de fabrication selon la revendication 7, dans lequel ladite partie en polymère électroconducteur est disposée sur ledit corps en utilisant un adhésif électroconducteur.

9. Procédé de fabrication selon la revendication 7, dans lequel l'étape de disposition comprend l'insertion de ladite partie en polymère électroconducteur dans une ouverture définie ou une partie concave qui est formée pour exposer au moins une partie des fibres de carbone.
